# EUROPÄISCHE PATENTSCHRIFT

(11) **EP 2 635 722 B1**
(45) Veröffentlichungstag und Bekanntmachung des Hinweises auf die Patenterteilung: **08.04.2015**
(21) Anmeldenummer: 11779621.9
(22) Anmeldetag: 28.10.2011
(51) Int. Cl.: H01L 31/18

(54) **VERFAHREN UND VORRICHTUNG ZUM KONTINUIERLICHEN BESCHICHTEN VON SUBSTRATEN**
METHOD AND DEVICE FOR CONTINUOUSLY COATING SUBSTRATES
PROCÉDÉ ET DISPOSITIF DE REVÊTEMENT DE SUBSTRATS EN CONTINU

(30) Priorität: 01.11.2010 DE 102010060292
(43) Veröffentlichungstag der Anmeldung: 11.09.2013
(73) Patentinhaber: Antec Solar GmbH, 99310 Arnstadt (DE)
(72) Erfinder: KREFT, Norbert, 77971 Kippenheim (DE); OELTING, Stefan, 99310 Wachsenburggemeinde (DE)
(74) Vertreter: Lohr, Georg
(86) Internationale Anmeldenummer: PCT/EP2011/069056
(87) Internationale Veröffentlichungsnummer: WO 2012/059439

(56) Entgegenhaltungen:
- EP-A1- 0 337 369
- EP-A1- 1 970 474
- EP-A2- 1 903 614
- WO-A1-02/24984
- DE-A1-102010 061 259
- US-A- 3 408 224
- US-A1- 2010 154 712

## Beschreibung

### Technisches Gebiet

Die Erfindung betrifft ein Verfahren nach dem Oberbegriff des Anspruchs 1 sowie eine dazu geeignete Vorrichtung. Nach dem Verfahren wird ein Halbleitermaterial in einem Tiegel verdampft und zu einer Oberfläche eines zu beschichtenden Substrates geführt, wo es abgeschieden wird.

### Stand der Technik

Verfahren der einleitend angegebenen Gattung dienen der Herstellung von sogenannten Dünnschichtsolarzellen. Dabei werden Glastafeln mit Halbleitermaterialien beschichtet, so dass ein np-Übergang entsteht. Ein entsprechendes Verfahren ist beispielsweise aus der WO 1993/023881 bekannt. In dieser Druckschrift wird das sogenannte "Closed Spaced Sublimationsverfahren", auch "CSS-Verfahren" genannt, beschrieben. Bei dem CSS-Verfahren werden Halbleitermaterialen, wie z.B. CdTe (Cadmiumtellurid) in geschlossenen Reaktoren (nachfolgend CSS-Reaktoren) sublimiert und auf Glastafeln abgeschieden. In der WO 1993/023881 wird vorgeschlagen das Ausgangsmaterial in einer Vielzahl von nebeneinander über einer Glastafel angeordneten Tiegeln zu sublimieren, so dass es auf der Glastafel abgeschieden wird. Der Vorteil des CSS-Verfahrens ist die Vermeidung von teurer Reinraumtechnik. Außerdem wird eine Kontamination der Umgebung mit Cadmium (Cd) und/oder Tellur (Te) vermieden.

Zur Herstellung von CdTe-Solarzellen wird ein für ein möglichst transparentes Substrat, meist eine Glastafel zunächst mit einer TCO-Schicht, das ist eine elektrisch leitende transparente Oxidschicht z.B. aus Zinkoxid (ZnO), Zinnoxid (SnO₂), Indiumoxid (In₂O₂), Indium-Zinnoxid auch ITO genannt (Mischung aus ZnO und In₂O₃) oder Cadmiumstanat (CdSnO₄) beschichtet. Die TCO-Schicht dient zur Kontaktierung einer darauf aufgebrachten Cadmiumsulfidschicht (CdS-Schicht). Auf die CdS-Schicht wird dann eine CdTe Schicht aufgebracht, auf die dann eine weitere leitende Schicht zur Kontaktierung aufgebracht wird. Natürlich können die Schichten auch in umgekehrter Folge auf ein Substrat aufgebracht werden und dann mit einer transparenten Scheibe, z.B. einer Glastafel abgedeckt werden.

Die einzelnen Schichten werden in der Regel strukturiert, um auf einer Glastafel eine Vielzahl von in Reihe geschalteten photovoltaischen Zellen zu erzeugen.

In der Offenlegungsschrift DE 10 2009 009 022 ist ein Verfahren zur physikalischen Dampfabscheidung von Chalkogenen auf einem Substrat beschrieben. Dazu wird das Substrat durch eine Gasschleuse in eine Prozesskammer eingebracht. Die Gasschleuse dichtet die Prozesskammer gegen das Eindringen von Sauerstoff ab. Zum Beschichten des Substrates wird ein Chalkogendampf-Trägergasgemisch in die Prozesskammer eingeleitet, so dass der Chalkogendampf auf dem Substrat kondensiert. Zur Erzeugung des Chalkogendampfes fallen Selenkugeln aus einem Reservoir in eine Dosiervorrichtung, die vereinzelte Selenkugeln über eine durch ein Kugelventil verschließbare Leitung an einen beheizten Graphittiegel abgibt. In dem Graphittiegel verflüssigt sich das Selen zunächst um dann zu verdampfen. Der Selendampf wird durch Stickstoff als Trägergas in die Prozesskammer geleitet.

In der Offenlegungsschrift US 2006/023 69 39 A1 ist ein Verfahren zum Beschichten eines Substrates mit einem Halbleiter beschrieben. Dazu wird ein Halbleiterdampf-Trägergasgemisch in eine Prozesskammer eingeleitet und gegen das Substrat gerichtet. Zur Herstellung des Gemisches wird ein Halbleiterpulver einem Reservoir entnommen und mit dem Trägergas in einem Rohrsystem transportiert. Während des Transportes wird das Halbleiterpulver durch Wärmezufuhr verdampft.

DE 10 2010 061 259 A1 betrifft ein Verfahren zur Abscheidung von CdTe. Durch nicht näher beschriebene Schleusen soll CdTe-Rohmaterial in einen Sublimationstiegel nachgefüllt werden, ohne den Beschichtungsprozess zu unterbrechen

### Darstellung der Erfindung

Der Erfindung liegt Beobachtung zugrunde, dass der CSS-Reaktor geöffnet werden muss, um Halbleitermaterial, z.B. CdTe und/oder CdS nachzufüllen. Dadurch wird die Produktion unterbrochen, zumindest wird der CdTe-Druck in dem CSS-Reaktor reduziert. Zudem gibt es eine ganze Reihe weiterer Nachteile: Durch das Nachfüllen von CdTe in den Tiegel sinkt die Sublimationsrate, was zu einer ungleichmäßigen Beschichtung der Substrate führt. Weil der Reaktor geöffnet werden muss, können giftige Stoffe wie z.B. Cd oder Te in die Umgebung gelangen. Zwar kann diese Gefahr reduziert werden, wenn man den Reaktor auf etwa Umgebungstemperatur abkühlen lässt, bevor er geöffnet wird, jedoch hat dies den Nachteil, dass die anschließend notwendige Aufheizphase die Rüstzeit zum Nachfüllen deutlich verlängert und beim Wiederanfahren der Produktion zunächst mit Qualitätseinbußen gerechnet werden muss, weil die Anlage noch nicht vollständig im thermischen Gleichgewicht ist. Zudem ist bei dem CSS-Verfahren der Reaktor in der Regel entweder evakuiert oder mit einem inerten Trägergas gefüllt. Ist der Reaktor evakuiert, dann muss er vor dem Öffnen belüftet werden. Insbesondere das anschließend notwendige Evakuieren des Reaktors verlängert die Rüstzeit. Wenn der Reaktor bei der Sublimation mit einem inerten Trägergas gefüllt ist, muss diese inerte Atmosphäre nach dem Füllen des Tiegels erst wieder hergestellt werden, bevor die Produktion wieder aufgenommen werden kann.

Der Erfindung liegt die Aufgabe zugrunde die beim Nachfüllen von Halbleitermaterial in einen Tiegel eines CSS-Reaktors entstehenden Qualitätsschwankungen zu reduzieren.

EP 1970 474 A1 offenbart eine MBE-Einrichtung und ein entsprechendes Verfahren zum Aufdampfen von CIS-Schichten auf ein Substrat. Dazu wird ein Molekularstrahl durch eine schlitzförmige Aperturblende einer Effusionszelle auf ein bandförmiges Substrat gerichtet. Die Aperturblende erstreckt sich über die ganze Breite des Substrats, so dass ein bandförmiges Substrat in seiner ganzen Breite bedampft werden kann, während es orthogonal zur Längserstreckung der Aperturblende bewegt wird. Die Breite der Aperturblende nimmt zum Rand derselben hinzu, um eine möglichst gleichmäßige Schicht auf das Substrat aufzubringen.

US 3,408,224 betrifft ein Verfahren zum Bedampfen eines Substrats mit einer Metallschicht. Dazu wird das zu verdampfende Metall zunächst unter Vakuum geschmolzen, um es zu entgasen und dann einem Tiegel durch ein System kommunizierender Röhren zugeführt.

EP 0 337 369 A1 betrifft die Beschichtung von nichtmetallischen Filmschichten mit Aluminium. Dazu werden die Substrate kontinuierlich über vor- bzw. nachgeschaltete Kammern mit reduziertem Druck in die Bedampfungskammer eingeführt. Am Boden der Bedampfungskammer wird Aluminium verdampft welches anschließend an dem darüber geführten Substrat kondensiert. Verdampftes Aluminium wird kontinuierlich ersetzt.

EP 1 903 614 A2 beschreibt betrifft ein CSS-Verfahren zur Abscheidung von CdTe auf der Oberseite von etwa 1m² großen Glastafeln und ist daher der nächstliegende Stand der Technik.

Diese Aufgabe wird durch ein Verfahren bzw. eine Vorrichtung nach den unabhängigen Ansprüchen gelöst. Vorteilhafte Ausgestaltungen der Erfindung sind in den abhängigen Ansprüchen angegeben.

Der Kern der Erfindung ist es Halbleitermaterial, z.B. CdTe und/oder CdS, in mindestens einen Tiegel eines CSS-Reaktors bei kontinuierlicher Verdampfung und bevorzugt auch kontinuierlicher Abscheidung von Halbleitermaterial auf ein Substrat nachzufüllen. Natürlich kann auch eine initale Befüllung des Tiegels nach dem erfindungsgemäßen Verfahren erfolgen.

Das Verfahren zum kontinuierlichen Beschichten mindestens eines Substrats hat zumindest die Schritte Verdampfen mindestens eines Halbleitermaterials, z.B. CdTe, in mindestens einem Tiegel und Abscheiden des Halbleitermaterials auf dem Substrat, wobei der Tiegel während des Verdampfens und/oder Abscheidens mit Halbleitermaterial befüllt wird. Das Verfahren wird in einem abgeschlossenen insbesondere evakuierten Reaktor, d.h. nach dem Prinzip der CSS, durchgeführt. Vor dem Nachfüllen von Halbleitermaterial, wie CdS und/oder CdTe, wird dieses zumindest auf +/- 20% der Temperatur des Halbleitermaterials im Tiegel vorgewärmt, dadurch werden beim Nachfüllen Schwankungen der mittleren Temperatur des Halbleitermaterials und damit der Sublimationsrate reduziert. Besonders bevorzugt wird der Druck in dem CSS-Reaktor und/oder die mittlere Temperatur des Halbleitermaterials in dem Tiegel zumindest in etwa konstant gehalten. Dies kann beispielsweise durch kontinuierliches Befüllen des Tiegels mit Halbleitermaterial erfolgen, wobei durch die Heizung des Tiegels die mittlere Temperatur konstant gehalten wird und/oder durch ein Vorwärmen des in den Tiegel einzufüllenden Halbleitermaterials.

Das nachzufüllende Halbleitermaterial wird z.B. in einer einem CSS-Reaktor vorgeschalteten Schleuse, zumindest in etwa (±20%, besonders bevorzugt ±5%) auf die Temperatur des Halbleitermaterials im Tiegel erwärmt. Sofern das nachzufüllende Halbleitermaterial mittels einer Schleuse in den Tiegel eingebracht wird, wird in der Schleuse, zumindest in einer Schleusenkammer, die Atmosphäre über dem Tiegel, bzw. in dem CSS Reaktor bevorzugt nachgebildet. Erfolgt die Beschichtung z.B. im Vakuum, wird aus der Schleuse bevorzugt die Luft oder ein sonstiges Gas abgezogen und das darin eingebrachte Halbleitermaterial darin erwärmt. Dadurch kann in der Schleuse die Atmosphäre des CSS-Reaktors nachgebildet werden. Natürlich kann die Schleuse mehrere Schleusenkammern aufweisen, in denen die Schritte nacheinander durchgeführt werden.

Die Begriffe Material und Halbleitermaterial bezeichnen hier sowohl das Ausgangsmaterial als auch das auf dem Substrat, z.B. einer Glastafel, abgeschiedene Material, wobei diese nicht zwingend identisch sein müssen. Der Tiegel ist typischerweise beheizt. Die Begriffe Tiegel und Sublimationstiegel werden als Synonym für ein zur Verdampfung von Material geeignetes Gefäß verwendet.

Bevorzugt wird das Halbleitermaterial zum Befüllen des Tiegels in mindestens eine erste Schleusenkammer eingebracht. Eine Schleusenkammer ist ein zwischen mindestens einer verschließbaren Einlassöffnung und mindestens einer verschließbaren Auslassöffnung angeordneter verschließbarer Raum. Über die Schleusenkammer kann das Halbleitermaterial zum Befüllen des Tiegels in einen CSS-Reaktor eingebracht werden, ohne dass der Innenraum des CSS-Reaktors unmittelbar mit der Außenwelt verbunden wird. Dazu öffnet man zunächst die ansonsten verschlossene Einlassöffnung der Schleusenkammer, bringt durch diese Halbleitermaterial in die Schleusenkammer ein, verschließt die Einlassöffnung der Schleusenkammer wieder, öffnet anschließend die ansonsten verschlossene Auslassöffnung der Schleusenkammer und verfrachtet das Halbleitermaterial durch die geöffnete Auslassöffnung der Schleusenkammer von der Schleusenkammer in den Reaktor.

Besonders bevorzugt wird nach dem Einbringen des Halbleitermaterials und vor dem Öffnen der Auslassöffnung die Atmosphäre in dem CSS-Reaktor nachgebildet und erst dann die Auslassöffnung der Schleusenkammer geöffnet. Dadurch kann verhindert werden, dass die Atmosphäre im CSS-Reaktor durch in der Schleusenkammer enthaltene Gase beeinflusst wird, d.h. der Prozess in dem CSS-Reaktor läuft weitgehend unbeeinflusst von Gasen in der Schleusenkammer ab. Dazu wird durch die Einlassöffnung Halbleitermaterial zum Befüllen des Tiegels in die Schleusenkammer eingebracht, wobei die Auslassöffnung verschlossen ist. Anschließend wird auch die Einlassöffnung verschlossen und die Atmosphäre des CSS-Reaktors wird nachgebildet. Im Fall dass in dem CSS-Reaktor ein Unterdruck herrscht wird die Schleusenkammer evakuiert, d.h. ein Vakuum erzeugt. Nun kann die Auslassöffnung geöffnet und das Halbleitermaterial in Richtung Tiegel verfrachtet werden. Somit steht der Begriff Vakuum hier nicht für einen theoretisch luftleeren Raum, sondern für einen Druck, der geringer ist als der Umgebungsdruck. Bevorzugt entspricht das Druckniveau in der Schleusenkammer nach Erzeugen des Vakuums zumindest in etwa (±20% bevorzugt ±5%) dem Druckniveau im CSS-Reaktor. Bei einigen CSS-Verfahren wird der Reaktor nicht evakuiert, sondern ist mit einem inerten Gas, z.B. einem Edelgas oder Stickstoff (N₂) gefüllt. Umfasst der Schritt des Nachbildens bevorzugt einleitenden von inertem Gas in die Schleusenkamm. Natürlich kann die Schleusenkammer vorher evakuiert werden. Bei einigen CSS-Verfahren herrscht in dem CSS-Reaktor ein geringerer Druck als Normdruck wobei der Restdruck zumindest im wesentlichen durch ein inertes Gas erzeugt wird. Auch diese Atmosphäre bildet man bevorzugt in der Schleusenkammer nach, bevor man die Auslassöffnung der Schleusenkammer öffnet.

Bevorzugt wird das Halbleitermaterial zum Nachfüllen des Tiegels in mindestens einer Schleusenkammer erwärmt, bevor es in den Tiegel eingefüllt wird. Dadurch können Temperaturschwankungen im Tiegel durch das Nachfüllen von Halbleitermaterial in den Tiegel auf ein Mindestmaß reduziert werden und der Sublimationsprozess wird durch das Nachfüllen von Halbleitermaterial nicht oder nur unwesentlich beeinflusst. Dadurch bleibt der Halbleitermaterialstrom vom Tiegel zum Substrat zumindest weitgehend konstant. Ebenso bleibt dann auch die Abscheiderate des Halbleitermaterials auf dem Substrat zumindest weitgehend konstant. Ein gleichmäßiges Schichtwachstum auf dem Substrat ist die Folge.

Besonders bevorzugt wird in die mindestens eine erste Schleusenkammer Halbleitermaterial eingebracht und dann in der ersten Schleusenkammer eine Atmosphäre erzeugt, die der Atmosphäre in dem CSS-Reaktor und einer zwischen der ersten Schleusenkammer und dem Reaktor angeordneten weiteren Schleusenkammer zumindest in etwa vom Druck entspricht. Sind der Reaktor und die weitere Schleusenkammer evakuiert, dann wird folglich die erste Schleusenkammer auch evakuiert. Anschließend wird das Halbleitermaterial in mindestens eine weitere Schleusenkammer verfrachtet. In der weiteren Schleusenkammer wird das verfrachtete Halbleitermaterial zumindest in etwa (±20%, bevorzugt ±5% oder besser) auf die Temperatur des Halbleitermaterials in dem Tiegel vorgewärmt. Das vorgewärmte Halbleitermaterial wird dann in den Tiegel eingefüllt. Dadurch wird weder die Temperatur in dem Tiegel, noch die Atmosphäre in dem CSS-Reaktor durch das Füllen des Tiegels wesentlich beeinflusst. Die Sublimationsrate und damit auch die Abscheiderate des Halbleitermaterials auf dem Substrat bleiben somit zumindest in etwa konstant. Dadurch kann der Prozess zur Abscheidung von Halbleitermaterial kontinuierlich durchgeführt werden, ohne dass wesentliche Qualitätsschwankungen der beschichteten Substrate auftreten. Weil der Vorgang des Erzeugens eines Unterdrucks und das Erwärmen des Halbleitermaterials in separaten Schleusen durchgeführt werden, werden diese Vorgänge notwendigerweise nacheinander durchgeführt. Somit sublimiert in der ersten Schleuse kein Halbleitermaterial, welches beim späteren erneuten Öffnen der Einlassöffnung in die Umwelt entweichen könnte.

Besonders bevorzugt wird bevor die Auslassöffnung der weiteren Schleuse geöffnet wird in der weiteren Schleusenkammer zumindest in etwa (±20%, bevozugt ±5% oder besser) der gleiche Partialdruck zu verdampfenden Halbleitermaterials erzeugt, wie in dem CSS-Reaktor. Dies kann insbesondere durch Aufheizen des Halbleitermaterials in der weiteren Schleuse unter zumindest im wesentlichen ähnlichen oder identischen atmosphärischen Bedingungen wie im CSS-Reaktor erfolgen. Beim Öffnen des Schleusenauslasses wird die Konzentration des gasförmigen Halbleitermaterials in dem CSS-Reaktor somit - wenn überhaupt - nur unerheblich beeinträchtigt, d.h. die Abscheiderate des Halbleitermaterials auf dem Substrat wird durch das Öffnen der Auslassöffnung der weiteren Schleuse nicht wesentlich beeinflusst. Insbesondere bei diesem Bespiel ist es sinnvoll,wenn der Druck in der ersten Schleuse zwischen dem Druck der weiteren Schleuse und dem Umgebungsdruck liegt. Dann entweicht beim Öffnen der Auslassöffnung der ersten Schleuse - wenn überhaupt - nur sehr wenig gasförmiges Halbleitermaterial in die erste Schleusenkammer.

Besonders einfach lässt sich dieses Verfahren durchführen, wenn die Auslassöffnung der ersten Schleusenkammer mit der Einlassöffnung der weiteren Schleusenkammer verbunden ist und die Auslassöffnung der weiteren Schleusenkammer gleichzeitig die Einlassöffnung in den Reaktor ist. Insbesondere kann die erste Schleusenkammer oberhalb der weiteren Schleusenkammer und die weitere Schleusenkammer wiederum oberhalb des Reaktors angeordnet sein. Dann genügt es die entsprechenden Ein- bzw. Auslassöffnungen zu öffnen und das Halbleitermaterial rutscht oder fällt schwerkraftbedingt von der ersten Schleuse in die weitere Schleuse und von dort in den Tiegel.

Bevorzugt wird Halbleitermaterial von der ersten Schleusenkammer in mindestens zwei weitere Schleusenkammern verfrachtet, von denen es abwechselnd in den Tiegel eingefüllt wird, dadurch wird die Zufuhr von Halbleitermaterial in den Tiegel kontinuierlicher. Schwankungen der Sublimationsrate und somit auch der Abscheiderate des Halbleitermaterials auf dem Substrat werden reduziert.

Eine Vorrichtung zur kontinuierlichen Abscheidung eines Halbleitermaterials auf einem Substrat nach dem CSS-Verfahren hat zumindest einen abgeschlossenen CSS-Reaktor in dem mindestens ein Tiegel zum Sublimieren von Halbleitermaterial angeordnet ist, sowie mindestens eine Aufnahme für mindestens ein Substrat, das auf der Aufnahme derart angeordnet werden kann, dass zuvor sublimiertes Halbleitermaterial auf dem Substrat abgeschieden wird. Die Vorrichtung weist zudem mindestens eine erste Schleuse mit einer zwischen mindestens einer Einlassöffnung und mindestens einer Auslassöffnung angeordneten ersten Schleusenkammer zum Vorhalten von Halbleitermaterial und bevorzugt auch Mittel zum Evakuieren der Schleuse auf.

Bevorzugt weist die Vorrichtung wenigstens eine weitere Schleusenkammer oder Schleuse mit einer zwischen einer Einlassöffnung und einer Auslassöffnung angeordneten weiteren Schleusenkammer und Mittel zum Beheizen von in die weitere Schleuse eingebrachtem Halbleitermaterial auf. Die weitere Schleuse bzw. Schleusenkammer ist bevorzugt zwischen der ersten Schleuse und dem Reaktor angeordnet. Der Druck in der weiteren Schleusenkammer entspricht bevorzugt zumindest in etwa dem Druck im Innenraum des Reaktors.

Wenn die Auslassöffnung der ersten Schleuse oberhalb der Einlassöffnung der weiteren Schleuse angeordnet ist, dann kann Halbleitermaterial durch die Schwerkraft von der ersten Schleuse in die weitere Schleuse verfrachtet werden, indem man einfach die entsprechenden Einlass- bzw. Auslassöffnungen öffnet. Die Auslassöffnung der ersten Schleuse und die Einlassöffnung der weiteren Schleuse können identisch sein. Man sollte bei der Anordnung der Auslass- bzw. Einlassöffnung lediglich darauf achten, dass das Halbleitermaterial durch die Schwerkraft von der einen in die weitere Schleuse verfrachtet wird, z.B. fällt oder rutscht, wenn die Auslass- bzw. Einlassöffnung geöffnet wird. Die Auslassöffnung ist dafür entsprechend, bevorzugt am tiefsten Bereich der einen Schleuse, angeordnet, ansonsten muss das Halbleitermaterial aktiv, z.B. durch ein Fördermittel wie einen Rüttelförderer zur Auslassöffnung befördert werden.

Wenn die Auslassöffnung der weiteren Schleuse oberhalb des Tiegels angeordnet ist, dann fällt oder/und rutscht beim Öffnen der Auslassöffnung der weiteren Schleuse zuvor dorthin verfrachtetes Halbleitermaterial in den Tiegel. Die Auslassöffnung ist dafür entsprechend, bevorzugt am tiefsten Bereich der weiteren Schleuse angeordnet. Alternativ kann die Auslassöffnung der weiteren Schleuse oberhalb eines Vorratsbehälters angeordnet sein, von wo aus das Halbleitermaterial in kleinen Portionen in den Tiegel eingefüllt wird. Besonders bevorzugt wird das Halbleitermaterial kontinuierlich z.B. durch ein entsprechendes Fördermittel wie z.B. einen Rüttelförderer oder eine Schnecke in den Tiegel befördert. Je gleichmäßiger das Halbleitermaterial in den Tiegel gefüllt wird, umso gleichmäßiger verdampft das Halbleitermaterial im Tiegel, d.h. Verdampfungsrate schwankt, wenn überhaupt, nur in engen Grenzen. Deshalb wird die Abscheidung des Halbleitermaterials auf dem Substrat durch das Befüllen des Tiegels nicht wesentlich beeinträchtigt.

Bevorzugt wird das Halbleitermaterial in dem Tiegel verteilt. Durch das Verteilen des Halbleitermaterials kann bei und/oder nach jedem Füllen des Tiegels die Oberfläche des Halbleitermaterials zumindest in etwa konstant gehalten werden. Dadurch wird die Verdampfungsrate und somit auch die Abscheiderate weiter vergleichmäßigt. Zum Verteilen des Halbleitermaterials kann der Tiegel z.B. gerüttelt werden. Dazu weist er bevorzugt Mittel zum Rütteln auf.

Der Tiegel ist bevorzugt in einem CSS-Reaktor oberhalb und/oder neben dem Substrat angeordnet, dadurch kann Halbleitermaterial problemlos von oben nachgefüllt werden. An den Rand des Tiegels ist bevorzugt ein Kanal angesetzt, dessen dem Tiegel abgewandtes Ende nach unten geöffnet oberhalb des Substrates endet. Der Kanal ist bevorzugt gemeinsam mit dem Tiegel in einem Ofen angeordnet. Wenn der Kanal zusätzlich beheizt ist, wird vermieden, dass er sich im Laufe der Zeit zusetzt. Deshalb ist Temperatur der Kanalwandung bevorzugt größer als die Temperatur des Halbleitermaterials in dem Tiegel. Nach dem Stand der Technik wurden Substrate oft von unten beschichtet. Gegenüber diesem Stand der Technik weist das die Erfindung den Vorteil auf, dass bei der beschriebenen Beschichtung des Substrates von oben das Substrat an seiner Unterseite großflächig oder zumindesten an eng aneinander anliegenden Stellen abgestützt werden kann. Dadurch wird ein Durchhängen der ansonsten nur im Randbereich abgestützten Substrate verhindert und die Prozesstemperatur kann erhöht werden, was z.B. bei CdTe-Dünnschichtsolarmodulen zu einem verbesserten Wirkungsgrad führt.

In dem Kanal ist bevorzugt in seinem Endabschnitt mindestens ein Gitter angeordnet, um die Strömungsgeschwindigkeit des gasförmigen Halbleitermaterials in Richtung Substrat über den Kanalquerschnitt zu vergleichmäßigen. Das Gitter ist bevorzugt beheizt, wodurch verhindert werden kann, dass es sich mit Halbleitermaterial zusetzt. Die Temperatur des Gitters sollte größer gleich der Temperatur des Materials in dem Tiegel sein. Das Gitter kann beispielsweise eine leitfähigen Platte mit einer Vielzahl von Löchern sein.

Bevorzugt hat der CSS-Reaktor mindestens eine verschließbare Öffnung durch die Halbleitermaterial in den Tiegel eingefüllt werden kann. Die verschließbare Öffnung kann z.B. in der Wandung des Kanals oder auch in der Tiegelwandung angeordnet sein, sie sollte oberhalb der maximalen Füllhöhe des Tiegels sein. Dann fällt durch die Öffnung gegebenes Halbleitermaterial in den Tiegel, somit wird der Tiegel gefüllt.

Die verschließbare Öffnung ist bevorzugt eine Auslassöffnung einer Schleuse und/oder einer Schleusenanordnung aus mindestens zwei Schleusen.

Bevorzugt hat der CSS-Reaktor Mittel zum Verteilen von Halbleitermaterial in dem Tiegel, z.B. Mittel zum Rütteln des Tiegels. Insbesondere beim Nachfüllen von pulverförmigen Halbleitermaterial in den Tiegel bildet sich ein Kegel. Durch den Kegel ist die Materialoberfläche, d.h. die Oberfläche des Halbleitermaterials an der dieses verdampft, größer als vor dem Einfüllen. Entsprechend steigt die Verdampfungsrate. Mit der Verdampfungsrate steigt auch die Abscheidegeschwindigkeit des Halbleitermaterials auf dem Substrat. Wenn nun nach dem Nachfüllen das Halbleitermaterial in dem Tiegel gleichmäßig verteilt wird, z.B. durch Rütteln des Tiegels, können Schwankungen der Materialoberfläche und somit auch der Abscheiderate minimiert werden.

### Beschreibung der Zeichnungen

Die Erfindung wird nachstehend ohne Beschränkung des Erfindungsgedankens anhand von Ausführungsbeispielen unter Bezugnahme auf die Zeichnung exemplarisch beschrieben.

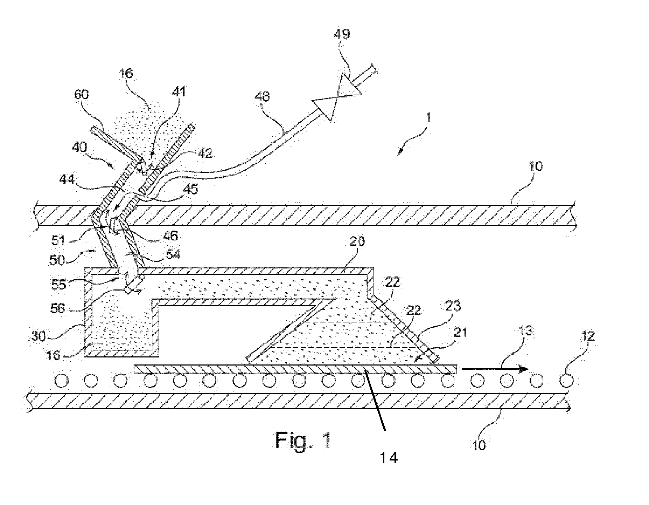

Die einzige Figur (Fig. 1) zeigt eine Skizze eines CSS-Reaktors zur Sublimation von Halbleitermaterial, z.B. Cadmiumtellurid (CdTe) und/oder Cadmiumsulit (CdS) und Desublimation des Halbleitermaterials auf einem Substrat im Schnitt.

Der CSS-Reaktor 1 ist ein Modul einer Fertigungsstrecke für Dünnschichtsolarmodule. Er ist geeignet zum Beschichten von Substraten 14, wie z.B. Glastafeln mit einem Halbleitermaterial, wie z.B. CdTe. Der CSS-Reaktor 1 hat ein ist kanalartiges Gehäuse und kann beidseits mit anderen Modulen der Fertigungsstrecke verbunden werden.

In dem Gehäuse 10 ist eine Führung auf der Substrate wie 14 durch den CSS-Reaktor 1 bewegt werden können (angedeutet durch Pfeil 13). Dazu hat die Führung eine Vielzahl von Rollen 12 auf denen das Substrat 14 aufliegt. Zumindest einige der Rollen 12 sind angetrieben.

Zum Aufbringen von Halbleitermaterial 16 auf das Substrat ist in dem Gehäuse ein beheizter Tiegel 30 oberhalb der Führung angeordnet. Der Tiegel geht übergangslos in einen ebenfalls beheizten Kanal 20 über, dessen dem Tiegel abgewandtes offenes Ende 21, d.h. dessen dem Tiegel abgewandte Öffnung 21 möglichst knapp über dem Substrat 14 angeordnet ist. Der Endabschnitt 23 über dem Substrat 14 ist trichterförmig erweitert. In dem Endabschnitt 23 sind zwei Gitter 22 angeordnet.

Über dem Tiegel 30 ist eine Auslassöffnung 55 einer Schleusenanordnung aus einer ersten Schleuse 40 und einer weiteren Schleuse 50. Die erste Schleuse ist zumindest Teilweise außerhalb des Gehäuses angeordnet. Die weitere Schleuse ist bevorzugt zumindest zum Teil innerhalb des beheizten Gehäuses 10 angeordnet.

Die erste Schleuse hat eine Schleusenkammer 44. In die Schleusenkammer 44 mündet eine absperrbare Unterdruckleitung 48 zum Anschluss der Schleusenkammer 44 an eine Vakuumpumpe (nicht dargestellt). Am oberen Ende der Schleusenkammer 44 ist eine Einlassöffung 41 und am unteren Ende der Schleusenkammer 44 ist eine Auslassöffnung 45. Die Einlassöffnung 41 ist durch einen schematisch als Klappe dargestellten Verschluss 42 verschließbar. Wenn der Verschluss 42 geöffnet ist, dann kommuniziert die erste Schleusenkammer mit einem auf der ersten Schleuse 40 angeordneten Vorratsbehälter 60 für Halbleitermaterial 16. Auch die Auslassöffnung 45 ist durch einen schematisch als Klappe dargestellten Verschluss 46 verschließbar. Wenn die Auslassöffung geöffnet ist, dann kommuniziert die Schleusenkammer 44 der ersten Schleuse 40 mit einer weiteren Schleusenkammer 54 der weiteren Schleuse 50. Entsprechend hat die weitere Schleuse 50 an ihrem oberen Ende eine Einlassöffnung 51, die durch den Verschluss 46 verschließbar ist. Am unteren Ende der weiteren Schleuse 50 ist eine verschließbare Auslassöffnung 55 über dem Tiegel 30 angeordnet.

Zum Beschichten eines durch das Gehäuse 10 geführten Substrats 14 mit einem Halbleitermaterial 16 wird das Halbleitermaterial 16 in dem Tiegel 30 verdampft. Entsprechend werden zumindest der Tiegel und der Kanal beheizt. Zumindest die Einlassöffnung 41 der ersten Schleusenkammer 44 ist durch den Verschluss 42 verschlossen. Vorzugsweise ist auch zumindest die Auslassöffnung 45 der ersten Schleusenkammer 44 verschlossen. Das gasförmige Halbleitermaterial verteilt sich in dem Kanal. Durch die dem Tiegel 30 abgewandte Öffnung 21 des trichterförmigen Endabschnitts 23 des Kanals 20 tritt das gasförmige Halbleitermaterial 16 aus dem Kanal 20 aus und trifft auf das möglichst nah an der Öffnung 21 angeordnete Substrat 14. Auf dem Substrat 14 wird das Halbleitermaterial 16 abgeschieden, d.h. es wird durch die Wahl der Temperatur des Substrates desublimiert.

Die Gitter 22 dienen dazu die Strömungsgeschwindigkeit des gasförmigen Halbleitermaterials 16 über den Kanalquerschnitt zu vereinheitlichen. Dadurch wird das Halbleitermaterial gleichmäßiger als ohne Gitter 22 auf das Substrat abgeschieden. Die Gitter sind beheizt, damit sich möglichst wenig Halbleitermaterial an Ihnen anlagert, was zu einer Verstopfung der Gitter 22 führen würde. Das Beheizen kann sowohl indirekt als auch direkt, z.B. durch Leiten eines Stromes durch die Gitter 22 erfolgen. Anders als dargestellt sind die Gitter bevorzugt konvex gekrümmt. Dadurch wird die Strömungsgeschwindigkeit des gasförmigen Halbleitermaterials auch in dem erweiterten Endabschnitt 23 weitgehend homogen.

Die trichterförmige Erweiterung des Endabschnitts 23 hat den Vorteil, dass das Halbleitermaterial lokal relativ langsam, d.h. mit einer geringen Wachstumsrate abgeschieden wird. Das verbessert den Wirkungsgrad der späteren Dünnschichtsolarmodule. Gleichzeitig wird aber großflächig abgeschieden, so dass die notwendige Schichtstärke der Halbleiterschicht dennoch recht zügig erreicht wird, d.h. die Taktrate der Fertigungsstrecke wird erhöht.

Beim Beschichten des Substrats 14 mit Halbleitermaterial 16 wird der Vorrat in dem Tiegel 30 verbraucht. Um den Vorrat wieder aufzufüllen wird die Auslassöffnung 45 der ersten Schleusenkammer 40 verschlossen und die Einlassöffnung 41 der ersten Schleusenkammer 40 geöffnet. Nun gelangt in dem Vorratsbehälter vorgehaltenes Halbleitermaterial 16 in die erste Schleusenkammer. Nachdem eine gewünschte Menge Halbleitermaterial 16 in die erste Schleusenkammer 40 gefüllt wurde, wird die Einlassöffnung 41 wieder verschlossen. Anschließend wird die erste Schleusenkammer 44 über die Unterdruckleitung 48 evakuiert. Spätestens jetzt wird die Auslassöffnung 55 der weiteren Schleusenkammer 54 verschlossen und anschließend die Einlassöffnung 51 der weiteren Schleuse 50 geöffnet sowie die Auslassöffnung 41 der ersten Schleuse 40 geöffnet. Dadurch wird das Halbleitermaterial 16 in die weitere Schleusenkammer verfrachtet. Sofern nötig könnten nun beide Schleusenkammern 44, 54 über die Unterdruckleitung 48 entlüftet werden. Die Einlassöffnung 41 der weiteren Schleuse 40 wird wieder geschlossen und das Halbleitermaterial 16 in der weiteren Schleusenkammer auf eine Temperatur erwärmt, die zumindest in etwa der Temperatur des Halbleitermaterials in dem Tiegel entspricht. Sobald die gewünschte Temperatur erreicht wurde kann die Auslassöffnung 55 der weiteren Schleuse 50 geöffnet werden, wodurch das Halbleitermaterial aus der weiteren Schleuse 50 in den Tiegel 30 gefüllt wird.

Während das Halbleitermaterial 16 in der weiteren Schleuse 50 erwärmt wird, kann in die erste Schleuse 40 wieder Halbleitermaterial 16 eingebracht und anschließend wieder ein Vakuum in der ersten Schleuse 40 erzeugt werden. Dadurch kann unmittelbar nach dem Befüllen des Tiegels 30 aus der weiteren Schleuse 50 und dem nachfolgenden Verschließen der Auslassöffnung 55 der weiteren Schleuse 50 neues Halbleitermaterial 16 aus der ersten Schleuse 40 in die weitere Schleuse 50 verfrachtet werden. Diese ermöglicht eine höhere Taktung beim Befüllen des Tiegels 30. Entsprechend können bei gleicher Gesamtmenge an Halbleitermaterial 16 welches in den Tiegel 30 nachgefüllt wird die Einzelmengen, welche bei jedem Öffnen der Auslassöffnung 55 der weiteren Schleuse 50 in den Tiegel 30 gefüllt werden reduziert werden, wodurch die Verdampfungsrate in dem Tiegel 30 weniger beeinträchtigt wird.

Durch die Schleusenanordnung aus mindestens einer ersten Schleuse 40 und mindestens einer weiteren Schleuse 50 kann bei laufender Abscheidung Halbleitermaterial in den Tiegel 30 nachgefüllt werden. Die nach dem Stand der Technik notwendige Stillsetzung der Fertigungsstrecke zum Nachfüllen von Halbleitermaterial kann somit entfallen.

### Bezugszeichenliste

- 1: CSS-Reaktor
- 10: Gehäuse
- 12: Rolle (angetrieben)
- 13: Vorschubrichtung
- 16: CdTe
- 20: Kanal
- 21: dem Tiegel abgewandte Öffnung des Kanals 20
- 22: Gitter
- 23: dem Tiegel abgewandter Endabschnitt des Kanals 20
- 30: Tiegel
- 40: erste Schleuse
- 41: Einlassöffnung
- 42: Verschluss zum Verschließen der Einlassöffnung der ersten Schleuse
- 44: Schleusenkammer der ersten Schleuse
- 45: Auslassöffnung
- 46: Verschluss zum Verschließen der Auslassöffnung der ersten Schleuse
- 48: Unterdruckleitung
- 49: Ventil
- 50: weitere Schleuse
- 51: Einlassöffnung
- 54: Schleusenkammer der weiteren Schleuse
- 55: Auslassöffnung der weiteren Schleuse
- 56: Verschluss zum Verschließen der Auslassöffnung der weiteren Schleuse
- 60: Vorratsbehälter

## Patentansprüche

1. Verfahren zum kontinuierlichen Beschichten mindestens eines Substrats (14) in einem CSS-Reaktor aufweisend zumindest die Schritte
- Verdampfen mindestens eines Halbleitermaterials (16) in mindestens einem Tiegel (30) und
- Abscheiden des Halbleitermaterials (16) von oben auf dem Substrat,
**dadurch gekennzeichnet, dass**
der Tiegel (30) während des Abscheidens und/oder Verdampfens mit Halbleitermaterial (16) befüllt wird und das Halbleitermaterial bevor es in den Tiegel gefüllt wird zumindest auf ±20% auf die Temperatur des Halbleitermaterials im Tiegel vorgewärmt wird.

2. Verfahren nach Anspruch 1,
**dadurch gekennzeichnet, dass**
Halbleitermaterial (16) zum Befüllen des Tiegels (30) in mindestens eine erste Schleusenkammer (44) eingebracht wird.

3. Verfahren nach Anspruch 2,
**dadurch gekennzeichnet, dass**
nach dem Einbringen des Halbleitermaterials (16) ein Vakuum in der ersten Schleusenkammer (44) erzeugt wird.

4. Verfahren nach Anspruch 2 oder 3,
**dadurch gekennzeichnet, dass**
das Halbleitermaterial (16) zum Befüllen des Tiegels (30) in mindestens einer Schleusenkammer (54) erwärmt wird, bevor es in den Tiegel (30) gefüllt wird.

5. Verfahren nach Anspruch 2, 3 und 4
**dadurch gekennzeichnet, dass**
- in die mindestens eine erste Schleusenkammer (44) Halbleitermaterial (16) eingebracht wird, und dann in der ersten Schleusenkammer (44) ein Vakuum erzeugt wird,
- anschließend das Halbleitermaterial (16) in mindestens eine weitere Schleusenkammer (54) verfrachtet wird,
- anschließend das Halbleitermaterial (16) in der weiteren Schleusenkammer (54) erwärmt wird, und
- das der Tiegel (30) mit dem erwärmten Halbleitermaterial (16) befüllt wird.

6. Verfahren nach Anspruch 5
**dadurch gekennzeichnet, dass**
das Halbleitermaterial (16) von der ersten Schleusenkammer (44) in mindestens zwei weitere Schleusenkammern (54) verfrachtet wird, von denen es abwechselnd in den Tiegel (30) eingefüllt wird.

7. CSS-Reaktor (1) zum Verdampfen mindestens eines Halbleitermaterials (16) mit mindestens einem Tiegel (30) oberhalb mindestens einer Führung für mindestens ein Substrat,
**dadurch gekennzeichnet, dass**
der CSS-Reaktor (1) mindestens eine erste Schleuse (40) mit einer zwischen mindestens einer Einlassöffnung (41) und mindestens einer Auslassöffnung (45) angeordneten Schleusenkammer (44) zum Vorhalten von Halbleitermaterial (16), Mittel zum Evakuieren der Schleuse (40), Mittel zum Erwärmen von Halbleitermaterial auf zumindest ±20%, der Temperatur des Halbleitermaterials im Tiegel und Mittel zum Verfrachten von Halbleitermaterial aus der Schleuse in den Tiegel hat.

8. CSS-Reaktor (1) nach Anspruch 7
**dadurch gekennzeichnet, dass**
der CSS-Reaktor (1) mindestens eine weitere Schleuse (50) mit einer zwischen mindestens einer Einlassöffnung (51) und mindestens einer Auslassöffnung(55) angeordneten weiteren Schleusenkammer (54) und Mittel zum Beheizen von in die weitere Schleuse (50) eingebrachtem Halbleitermaterial (16) aufweist.

9. Vorrichtung nach Anspruch 8
**dadurch gekennzeichnet, dass**
die weitere Schleuse (50) zwischen der mindestens einen ersten Schleuse (40) und dem Tiegel (30) angeordnet ist.

10. Vorrichtung nach Anspruch 9,
**dadurch gekennzeichnet, dass**
die Auslassöffnung (46) der ersten Schleuse (40) oberhalb der Einlassöffnung (51) der weiteren Schleuse (50) angeordnet ist.

11. Vorrichtung nach einem Anspruch 9 oder 10
**dadurch gekennzeichnet, dass**
die Auslassöffnung (56) der weiteren Schleuse (50) oberhalb des Tiegels (30) angeordnet ist.

12. Vorrichtung nach einem der Ansprüche 7 bis 11,
**dadurch gekennzeichnet, dass**
die Einlassöffnung (41) der ersten Schleuse (40) mit der Auslassöffnung eines Vorratsbehälters (60) verbunden ist.

13. Vorrichtung nach einem der Ansprüche 7 bis 12,
**dadurch gekennzeichnet, dass**
oberhalb des Tiegels (30) eine Öffnung eines Kanals (20) ist, der oberhalb der Führung ein offenes Ende aufweist, um verdampftes Halbleitermaterial (16) von dem Tiegel (30) durch den Kanal (20) zu der Oberseite mindestens eines auf der Führung gehalterten Substrats (14) zu leiten.

14. Vorrichtung nach Anspruch 13,
**dadurch gekennzeichnet, dass**
in dem Kanal (20) oder zumindest an einem seiner Enden mindestens ein Gitter (22) angeordnet ist.

15. Vorrichtung nach einem der Ansprüche 7 bis 14,
**dadurch gekennzeichnet, dass**
die Führung mindestens ein Stützelement (12) für ein Substrat (14) aufweist, wobei das Stützelement (12) mindestens eine zwischen den seitlichen Rändern des Substrats (14) angeordnete Auflage für das Substrat (14) aufweist, um ein Durchhängen des Substrats (14) zumindest zu reduzieren.

## Claims

1. Method for the continuous coating of at least one substrate (14) in an CSS reactor, comprising at least the steps
- evaporating at least one semiconductor material (16) in at least one crucible (30) and
- depositing the semiconductor material from above on the substrate,
**characterized in that**
the crucible (30) is filled with semiconductor material (16) during the deposition and/or evaporation and the semiconductor material is preheated to at least ±20 % of the semiconductor material in the crucible, prior to filling it into the crucible.

2. Method according to claim 1,
**characterized in that**
semiconductor material (16) for filling the crucible (30) is introduced into at least one first lock chamber (44).

3. Method according to claim 2,
**characterized in that**
after introducing the semiconductor material (16) a vacuum is produced in the first lock chamber (44).

4. Method according to claim 2 or 3,
**characterized in that**
the semiconductor material (16) for filling the crucible (30) is heated in at least one lock chamber (44) before it is filled into the crucible (30).

5. Method according to claim 2, 3 and 4
**characterized in that**
- semiconductor material (16) is introduced into the at least one first lock chamber (44), and then a vacuum is produced in the first lock chamber (44),
- the semiconductor material (16) is then loaded into at least one further lock chamber (54),
- the semiconductor material (16) is subsequently heated in the further lock chamber (54) and
- the crucible (30) is filled with the heated semiconductor material (16).

6. Method according to claim 5,
**characterized in that**
the semiconductor material (16) is loaded from the first lock chamber (44) into at least two further lock chambers (54) from which it is alternately poured into the crucible (30).

7. CSS reactor (1) for evaporating at least one semiconductor material (16), comprising at least one crucible (30) above at least one guide for at least one substrate,
**characterized in that**
the CSS reactor (1) has at least one lock (40) with a lock chamber (44) being arranged between at least one inlet opening (41) and at least one outlet opening (45) for holding the semiconductor material (16) available, means for evacuating the lock (40), means for heating the semiconductor material (16) to at least ±20 % of the temperature of the semiconductor material in the crucible, and means for loading semiconductor material from the lock into the crucible.

8. CSS reactor (1) according to claim 7
**characterized in that**
the CSS reactor (1) has at least one further lock (50) comprising a further lock chamber (54) between at least one inlet opening (51) and at least one outlet opening (55), and means for heating semiconductor material (16) introduced into the further lock (50).

9. Device according to claim 8
**characterized in that**
the further lock (50) is between the at least one first lock (40) and the crucible (30).

10. Device according to claim 9
**characterized in that**
the outlet opening (46) of the first lock (40) is above the inlet opening (51) of the further lock (50).

11. Device according to claim 9 or 10
**characterized in that**
the outlet opening (56) of the further lock (50) is above the crucible (30).

12. Device according to one of claims 7 to 11
**characterized in that**
the inlet opening (41) of the first lock (40) is connected to the outlet opening of a storage container (60).

13. Device according one of claims 7 to 12
**characterized in that**
an opening of a channel (20) is above the crucible (30), which channel has an open end above the guide, in order to guide evaporated semiconductor material (16) from the crucible (30) through the channel (20) to the upper side of at least one substrate (14) being supported on the guide.

14. Device according to claim 13,
**characterized in that**
at least one grid (22) is arranged in the channel (20) or at least at one of its ends.

15. Device according to one of claims 7 to 14
**characterized in that**
the guide comprises at least one support element (12) for a substrate (14), wherein the support element (12) comprises at least one support for the substrate (14) which is positioned between the lateral edges of the substrate (14), in order to at least reduce any sagging of the substrate (14).

## Revendications

1. Procédé pour le revêtement en continu d'au moins un substrat (14) dans un réacteur de sublimation CSS, comprenant au moins les étapes de :
- évaporation d'au moins un matériau semi-conducteur (16) dans au moins un creuset (30) et
- dépôt du matériau semi-conducteur (16) par le haut sur le substrat,
**caractérisé en ce que** le creuset (30) est rempli de matériau semi-conducteur (16) pendant le dépôt et/ou l'évaporation et le matériau semi-conducteur est préchauffé, avant d'être amené au creuset, au moins jusqu'à ±20 % de sa température dans le creuset.

2. Procédé selon la revendication 1, **caractérisé en ce que** le matériau semi-conducteur (16) pour le remplissage du creuset (30) est amené dans au moins une première chambre de sas (44).

3. Procédé selon la revendication 2, **caractérisé en ce qu'**après l'introduction du matériau semi-conducteur (16), un vide est créé dans la première chambre de sas (44).

4. Procédé selon la revendication 2 ou 3, **caractérisé en ce que** le matériau semi-conducteur (16) pour le remplissage du creuset (30) est chauffé dans au moins une chambre de sas (54) avant d'être amené dans le creuset (30).

5. Procédé selon les revendications 2, 3 et 4, **caractérisé en ce que**
- du matériau semi-conducteur (16) est introduit dans l'au moins une première chambre de sas (44) et un vide est ensuite créé dans la première chambre de sas (44),
- le matériau semi-conducteur (16) est ensuite transporté dans au moins une autre chambre de sas (54),
- le matériau semi-conducteur (16) est ensuite chauffé dans l'autre chambre de sas (54) et
- le creuset (30) est rempli avec le matériau semi-conducteur (16) chauffé.

6. Procédé selon la revendication 5, **caractérisé en ce que** le matériau semi-conducteur (16) est transporté de la première chambre de sas (44) vers au moins deux autres chambres de sas (54), à partir desquelles il est amené alternativement dans le creuset (30).

7. Réacteur de sublimation CSS (1) pour l'évaporation d'au moins un matériau semi-conducteur (16) avec au moins un creuset (30) au-dessus d'au moins un guidage pour au moins un substrat, **caractérisé en ce que** le réacteur de sublimation CSS (1) possède au moins un premier sas (40) avec une chambre de sas (44) disposée entre au moins une ouverture d'entrée (41) et au moins une ouverture de sortie (45) pour emmagasiner du matériau semi-conducteur (16), des moyens pour faire le vide dans le sas (40), des moyens pour chauffer le matériau semi-conducteur jusqu'à au moins ±20 % de sa température dans le creuset et des moyens pour transporter du matériau semi-conducteur du sas vers le creuset.

8. Réacteur de sublimation CSS (1) selon la revendication 7, **caractérisé en ce que** le réacteur de sublimation CSS (1) possède au moins un autre sas (50) avec une autre chambre de sas (54) disposée entre au moins une ouverture d'entrée (51) et au moins une ouverture de sortie (55) et des moyens pour chauffer du matériau semi-conducteur (16) introduit dans l'autre sas (50).

9. Dispositif selon la revendication 8, **caractérisé en ce que** l'autre sas (50) est disposé entre l'au moins un premier sas (40) et le creuset (30).

10. Dispositif selon la revendication 9, **caractérisé en ce que** l'ouverture de sortie (46) du premier sas (40) est disposée au-dessus de l'ouverture d'entrée (51) de l'autre sas (50).

11. Dispositif selon l'une des revendications 9 ou 10, **caractérisé en ce que** l'ouverture de sortie (56) de l'autre sas (50) est disposée au-dessus du creuset (30).

12. Dispositif selon l'une des revendications 7 à 11, **caractérisé en ce que** l'ouverture d'entrée (41) du premier sas (40) communique avec l'ouverture de sortie d'un réservoir (60).

13. Dispositif selon l'une des revendications 7 à 12, **caractérisé en ce qu'**il est prévu au-dessus du creuset (30) une ouverture d'un canal (20) qui présente une extrémité ouverte au-dessus du guidage afin d'amener du matériau semi-conducteur (16) évaporé par le canal (20) du creuset (30) vers la face supérieure d'au moins un substrat (14) retenu sur le guidage.

14. Dispositif selon la revendication 13, **caractérisé en ce qu'**au moins une grille (22) est disposée dans le canal (20) ou au moins à une de ses extrémités.

15. Dispositif selon l'une des revendications 7 à 14, **caractérisé en ce que** le guidage comprend au moins un élément de support (12) pour un substrat (14), lequel élément de support (12) présente au moins un appui pour le substrat (14) disposé entre les bords latéraux du substrat (14), afin d'au moins réduire une inflexion du substrat (14).
